# EUROPEAN PATENT SPECIFICATION

(11) **EP 3 647 836 B1**
(45) Date of publication and mention of the grant of the patent: **11.09.2024**
(21) Application number: 18823925.5
(22) Date of filing: 14.06.2018
(51) Int. Cl.: H01L 33/50, G02B 5/20, H01L 33/44, G02B 1/14

(54) **WAVELENGTH CONVERSION MEMBER AND LIGHT SOURCE**
WELLENLÄNGENUMWANDLUNGSELEMENT UND LICHTQUELLE
ÉLÉMENT DE CONVERSION DE LONGUEUR D'ONDE ET SOURCE DE LUMIÈRE

(30) Priority: 29.06.2017 JP 2017127638
(43) Date of publication of application: 06.05.2020
(73) Proprietor: Panasonic Intellectual Property Management Co., Ltd., Osaka-shi, Osaka 540-6207 (JP)
(72) Inventor: SUGIO, Yukihiko, Osaka-shi, Osaka 540-6207 (JP); HAMADA, Takahiro, Osaka-shi, Osaka 540-6207 (JP); SUZUKI, Nobuyasu, Osaka-shi, Osaka 540-6207 (JP); NAGASAKI, Yoshihisa, Osaka-shi, Osaka 540-6207 (JP)
(74) Representative: Müller-Boré & Partner Patentanwälte PartG mbB
(86) International application number: PCT/JP2018/022656
(87) International publication number: WO 2019/003927

(56) References cited:
- WO-A1-2012/077656
- WO-A1-2012/137552
- WO-A1-2013/172025
- JP-A- 2009 256 573
- JP-A- 2009 256 573
- JP-A- 2015 008 278
- JP-A- 2017 028 251
- US-A1- 2014 071 683

## Description

### TECHNICAL FIELD

The present disclosure relates to a wavelength conversion member and a light source.

### BACKGROUND ART

In recent years, a light source including a light emitting element and a wavelength conversion member has been developed. The wavelength conversion member has phosphor particles embedded in a matrix. The phosphor particles are irradiated with light from the light emitting element as excitation light, and light having a wavelength longer than the wavelength of the excitation light is radiated from the phosphor. It has been attempted to increase the luminance and output of light in this type of light source.

Patent Literature 1 discloses an LED sealing resin body in which a phosphor is dispersed in a silicone resin. Patent Literature 2 discloses a wavelength conversion member in which glass is used as a material for the matrix. Patent Literature 3 discloses a wavelength conversion member in which zinc oxide (ZnO) is used as a material for the matrix. ZnO is superior to a silicone resin in heat resistance. ZnO is an inorganic material having a refractive index close to the refractive index of a number of phosphors and exhibits excellent translucency and thermal conductivity. According to the wavelength conversion member of Patent Literature 3, light scattering at the interface between the phosphor particles and the ZnO matrix is suppressed and high light output can be achieved.

### Citation List

### Patent Literatures

PTL 1: International Publication No. 2011/111293
PTL 2: Unexamined Japanese Patent Publication No. 2011-168627
PTL 3: International Publication No. 2013/172025
PTL 4: US 2014/071683 A1 is directed at a wavelength conversion element that includes a phosphor layer including a plurality of phosphor particles and a matrix that is located among the plurality of phosphor particles and is formed of zinc oxide. The zinc oxide of PTL 4 is columnar crystals or a single crystal in a c-axis orientation.
PTL 5: JP 2009 256573 A is directed at a phosphor for a collision excitation type EL realizing full color light emission using as the base material a chemically extremely stable compound or composite oxide, a manufacturing method of a thin film of the phosphor, a thin film EL device using a thin film of the phosphor for a light emitting layer, a thin film EL display using the thin film EL device, and an EL lamp. The phosphor of PTL 5 for a collision excitation type electroluminescence contains a base material including a compound or a composite oxide having at least lanthanum (La) and oxygen (O) as its constituent elements, and at least one or more of metal elements as an activator.

### SUMMARY OF THE INVENTION

The wavelength conversion member of Patent Literature 3 has room for improvement from the viewpoint of reliability.

An object of the present discloser is to provide a wavelength conversion member exhibiting high reliability.

The present invention is defined by the features described in the independent claims. Additional embodiments are defined in the dependent claims.

According to the technology of the present disclosure, it is possible to provide a wavelength conversion member exhibiting high reliability.

### BRIEF DESCRIPTION OF DRAWINGS

FIG. 1 is a schematic sectional diagram of a wavelength conversion member according to a first example that does not show a full implementation of the invention but mainly serves for illustrative purposes.
FIG. 2 is a schematic sectional diagram of a wavelength conversion member according to a second example that does not show a full implementation of the invention but mainly serves for illustrative purposes.
FIG. 3 is a schematic sectional diagram of a wavelength conversion member according to an exemplary embodiment of the present invention.
FIG. 4 is a schematic sectional diagram of a reflective light source using a wavelength conversion member of the present disclosure.
FIG. 5 is a schematic configuration diagram of a lighting system using a light source of the present disclosure.
FIG. 6 is a laser microscope image diagram of a wavelength conversion member of Sample 1.
FIG. 7 is a laser microscope image diagram of a wavelength conversion member of Sample 2.
FIG. 8 is a graph showing the results attained by analyzing a wavelength conversion member of Sample 2 using an electron beam microanalyzer.
FIG. 9 is a graph showing a change in CIE chromaticity coordinates of light radiated from a wavelength conversion member of Sample 3.
FIG. 10 is a graph showing a change in CIE chromaticity coordinates of light radiated from a wavelength conversion member of Sample 5.
FIG. 11 is a graph showing a change in CIE chromaticity coordinates of light radiated from a wavelength conversion member of Sample 6.

### DESCRIPTION OF EMBODIMENT

### (Knowledge as basis of present disclosure)

In the wavelength conversion member of Patent Literature 3, ZnO contained in the matrix reacts with corrosive gas in the air in some cases. The reaction between ZnO and corrosive gas proceeds with time. As the above reaction proceeds with time, the chromaticity of light radiated from the wavelength conversion member changes with time in some cases.

The wavelength conversion member according to the invention is defined in claim 1.

Accordingly, the first protective layer suppresses permeation of corrosive gas in the air. For this reason, ZnO contained in the matrix of the phosphor layer hardly reacts with the corrosive gas. In other words, it is possible to suppress that the reaction between ZnO and the corrosive gas proceeds with time. By this, a change in chromaticity of light radiated from the wavelength conversion member with time is sufficiently suppressed. In other words, the wavelength conversion member exhibits high reliability.

Moreover, with ZnO of the wavelength conversion member being c-axis-oriented polycrystalline ZnO, light scattering in the phosphor layer is further suppressed. Hence, high light output can be achieved in the wavelength conversion member.

Furthermore, the strength of the wavelength conversion member is improved by the second protective layer. The permeation of corrosive gas can also be further suppressed by the second protective layer.

In a first optional aspect of the present disclosure, for example, the first protective layer of the wavelength conversion member is in contact with the phosphor layer. Accordingly, , a change in chromaticity the of light radiated from the wavelength conversion member with time is sufficiently suppressed.

In a second optional aspect of the present disclosure, for example, the phosphor layer of the wavelength conversion member further has filler particles. Accordingly, the wavelength conversion member radiates light having a required chromaticity.

In a third optional aspect of the present disclosure, for example, the thickness of the first protective layer of the wavelength conversion member is in a range of 0.5 µm to 20 µm. Accordingly, the first protective layer is sufficiently thin and a high luminous efficiency can be thus achieved.

The light source according to the present invention as defined in claim 5 includes a light emitting element and the wavelength conversion member according to the invention or one of its optional aspects that receives excitation light emitted from the light emitting element and radiates fluorescence.

Accordingly, it is possible to provide a light source in which a change in the chromaticity of light with time is sufficiently suppressed. In other words, the light source exhibits high reliability.

Hereinafter, examples for illustrative purposes and embodiments of the present disclosure will be described with reference to the drawings. The present disclosure is not limited to the following exemplary embodiments.

### (First example)

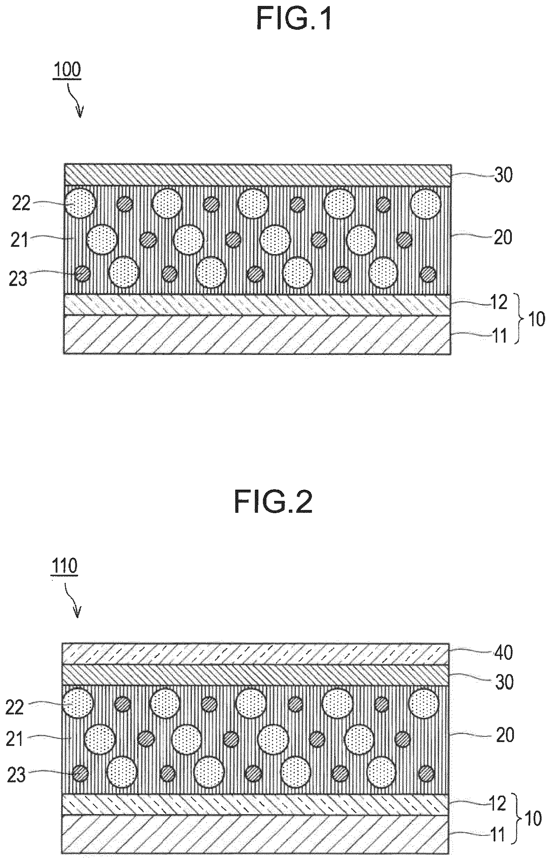

As illustrated in FIG. 1, wavelength conversion member 100 according to the first example includes substrate 10, phosphor layer 20, and first protective layer 30. While this first example does not fully implement the claimed invention and mainly serves for illustrative purposes, parts of the disclosure herein may be used in connection with the claimed invention as will be described further below. Substrate 10 supports phosphor layer 20 and first protective layer 30. Phosphor layer 20 is disposed on substrate 10. Phosphor layer 20 covers the entire surface of substrate 10. Phosphor layer 20 may only partially cover the surface of substrate 10. The lower surface of phosphor layer 20 is in contact with the upper surface of substrate 10.

First protective layer 30 is disposed on phosphor layer 20. Phosphor layer 20 is disposed between substrate 10 and first protective layer 30. In other words, substrate 10, phosphor layer 20, and first protective layer 30 are arranged in the thickness direction of wavelength conversion member 100 in this order. First protective layer 30 covers the entire surface of phosphor layer 20. First protective layer 30 may only partially cover the surface of phosphor layer 20. The lower surface of first protective layer 30 is in contact with the upper surface of phosphor layer 20.

Phosphor layer 20 has matrix 21 and phosphor particles 22. Phosphor layer 20 may further have filler particles 23. Matrix 21 exists between the respective particles. The respective particles are embedded in matrix 21. In other words, the respective particles are dispersed in matrix 21.

When wavelength conversion member 100 is irradiated with excitation light having a first wavelength band, wavelength conversion member 100 converts a part of the excitation light into light having a second wavelength band and radiates the light. Wavelength conversion member 100 radiates light having a wavelength longer than the wavelength of the excitation light. The second wavelength band is a band different from the first wavelength band. However, a part of the second wavelength band may overlap the first wavelength band. The light radiated from wavelength conversion member 100 may include not only the light radiated from phosphor particles 22 but also the excitation light itself.

Substrate 10 has substrate main body 11 and thin film 12. The thickness of substrate 10 is, for example, thicker than the thickness of phosphor layer 20. Substrate main body 11 contains at least one selected from the group consisting of sapphire (Al₂O₃), gallium nitride (GaN), aluminum nitride (AIN), silicon, aluminum, glass, quartz (SiO₂), silicon carbide (SiC), and zinc oxide. For example, substrate main body 11 may or may not exhibit translucency with respect to the excitation light and the light radiated from phosphor particles 22. Substrate main body 11 may have a mirror-polished surface.

The surface of substrate main body 11 may be covered with an antireflective film, a dichroic mirror, a metal reflective film, a reflection enhancing film, a protective film, and the like. The antireflective film is a film for preventing reflection of excitation light. The dichroic mirror can be composed of a dielectric multilayer film. The metal reflective film is a film for reflecting light and is fabricated of a metal material such as silver or aluminum. The reflection enhancing film can be composed of a dielectric multilayer film. The protective film can be a film for physically or chemically protecting these films.

Thin film 12 functions as a ground layer for forming phosphor layer 20. When matrix 21 of phosphor layer 20 is crystalline, thin film 12 functions as a seed crystal in the crystal growth process of matrix 21. In other words, thin film 12 is a single crystalline thin film or a polycrystalline thin film. When matrix 21 is composed of single crystalline ZnO or polycrystalline ZnO, thin film 12 can be a single crystalline ZnO thin film or a polycrystalline ZnO thin film. However, thin film 12 may be omitted in a case in which substrate main body 11 can exert the function of the seed crystal. For example, when substrate main body 11 is composed of crystalline GaN or crystalline ZnO, matrix 21 composed of crystalline ZnO can be formed directly on substrate main body 11.

In phosphor layer 20, phosphor particles 22 are dispersed in matrix 21. In FIG. 1, phosphor particles 22 are separated from each other. Filler particles 23 are also separated from phosphor particles 22. However, phosphor particles 22 may be in contact with each other or filler particles 23 may be in contact with phosphor particles 22. A plurality of filler particles 23 may be in contact with phosphor particles 22. Phosphor particles 22 and filler particles 23 may be stacked like a stone wall.

Phosphor particles 22 receive excitation light and radiate fluorescence. The material for phosphor particles 22 is not particularly limited. Various fluorescent substances can be used as the material for phosphor particles 22. Specifically, fluorescent substances such as Y₃Al₅O₁₂:Ce(YAG), Y₃(Al,Ga)₅O₁₂:Ce(GYAG), Lu₃Al₅Ol₂:Ce(LuAG), (Si,Al)₆(O,N)₈:Eu(β-SiAlON), (La,Y)₃Si₆N₁₁:Ce(LYSN, La₃Si₆N₁₁:Ce(LSN), Lu₂CaMg₂Si₃O₁₂:Ce(LCMS), Sr₂SiO₄:Eu, (Ba,Sr)Si₂O₂N₂:Eu, Ca₃Sc₂Si₃O₁₂:Ce, and CaSi₂O₂N₂:Eu can be used. Phosphor particles 22 may include plural kinds of phosphor particles having different compositions. The material for phosphor particles 22 is selected in accordance with the chromaticity of light that should be radiated from wavelength conversion member 100.

The average particle diameter of phosphor particles 22 is, for example, in a range of 0.1 µm to 50 µm. The average particle diameter of phosphor particles 22 can be specified by the following method, for example. First, the cross section of wavelength conversion member 100 is observed under a scanning electron microscope. In the electron microscope image attained, the area of specific phosphor particle 22 is calculated by image processing. The diameter of a circle having the same area as the calculated area is regarded as the particle diameter (diameter of particle) of specific phosphor particle 22. The particle diameters of an arbitrary number (for example, 50) of phosphor particles 22 are calculated, and the average value of the calculated values is regarded as the average particle diameter of phosphor particles 22. In the present disclosure, the shape of phosphor particles 22 is not limited. The shape of phosphor particles 22 may be a spherical shape, a scaly shape, or a fibrous shape. In the present disclosure, the method for measuring the average particle diameter is not limited to the above method.

Matrix 21 contains ZnO. ZnO is suitable as the material for matrix 21 from the viewpoints of transparency and thermal conductivity. ZnO exhibits high thermal conductivity. Hence, when ZnO is used as the material for matrix 21, the heat of phosphor layer 20 can be easily released to the outside (mainly to substrate 10). Matrix 21 may contain ZnO as a main component. The "main component" means a component that is contained in matrix 21 in the greatest amount as a weight ratio. Matrix 21 may be composed substantially of ZnO. "To be composed substantially of" means to exclude other components which alter the essential features of the mentioned compound. However, matrix 21 may contain impurities in addition to ZnO.

In detail, ZnO as the material for matrix 21 is single crystalline ZnO or c-axis-oriented polycrystalline ZnO. ZnO has a wurtzite crystal structure. "c-axis-oriented ZnO" means that the plane parallel to the principal surface (the surface having the largest area) of substrate 10 is the c-plane. When matrix 21 contains c-axis-oriented polycrystalline ZnO, light scattering is suppressed inside phosphor layer 20 and high light output can be achieved.

C-axis-oriented polycrystalline ZnO includes a plurality of columnar crystal grains oriented in the c-axis. In c-axis-oriented polycrystalline ZnO, there are few crystal grain boundaries in the c-axis direction. The "columnar crystal grains are oriented in the c-axis" means that the growth of ZnO in the c-axis direction is faster than the growth of ZnO in the a-axis direction and vertical ZnO crystal grains are formed on substrate 10. The c-axis of ZnO crystal grain is parallel to the normal direction of substrate 10. Alternatively, the inclination of the c-axis of ZnO crystal grain with respect to the normal direction of substrate 10 is 4° or less. Here, the fact that "inclination of c-axis is 4° or less" means that the distribution of inclination of the c-axis is 4° or less but does not necessarily mean that the inclination of the c-axis of all crystal grains is 4° or less. The "inclination of c-axis" can be evaluated by the half-value width of the c-axis by the X-ray rocking curve method. In detail, the half-value width of the c-axis by the X-ray rocking curve method is 4° or less. Patent Literature 3 (International Publication No. 2013/172025) discloses a matrix composed of c-axis-oriented polycrystalline ZnO in detail.

In phosphor layer 20, filler particles 23 are dispersed in matrix 21. When filler particles 23 are irradiated with excitation light, filler particles 23 do not radiate fluorescent light or radiate only fluorescent light with an negligible intensity. The material, shape, and added amount of filler particles 23 are appropriately adjusted in accordance with the required chromaticity.

Filler particles 23 are, for example, inorganic particles and typically contain a metal oxide. Filler particles 23 may be composed substantially of a metal oxide. A number of metal oxides are chemically stable and hardly radiate fluorescence and thus are suitable as materials for filler particles 23. In an example, filler particles 23 contain at least one selected from Al₂O₃ particles, SiO₂ particles, or TiO₂ particles.

The average particle diameter of filler particles 23 is, for example, in a range of 0.1 um to 20 µm. The average particle diameter of filler particles 23 is, for example, smaller than the average particle diameter of phosphor particles 22. The ratio (D2/D1) of average particle diameter D2 of filler particles 23 to average particle diameter D1 of phosphor particles 22 is, for example, in a range of 0.01 to 0.90. The average particle diameter of filler particles 23 can be measured by the same method as the method for the average particle diameter of phosphor particles 22. The shape of filler particles 23 may be a spherical shape, a scaly shape, or a fibrous shape. The volume of phosphor particles 22 is defined as V1. The volume of filler particles 23 is defined as V2. At this time, the value of V2/(V1 + V2) is, for example, in a range of 0.1 to 0.9.

First protective layer 30 contains at least one selected from the group consisting of ZnCl₂, ZnS, and ZnSO₄. These compounds hardly react with corrosive gas in the air. The corrosive gas is, for example, gas containing at least one selected from the group consisting of H₂S, Cl₂, NO₂, and SO₂. First protective layer 30 hardly reacts with the corrosive gas. First protective layer 30 suppresses permeation of corrosive gas. Hence, ZnO contained in matrix 21 hardly reacts with the corrosive gas. In other words, it is possible to suppress that the reaction between ZnO and the corrosive gas proceeds with time. By this, a change in chromaticity of light radiated from wavelength conversion member 100 with time is sufficiently suppressed. In other words, wavelength conversion member 100 exhibits high reliability.

First protective layer 30 may contain at least one selected from the group consisting of ZnCl₂, ZnS, and ZnSO₄ as a main component. First protective layer 30 may contain any one selected from the group consisting of ZnClz, ZnS, and ZnSO₄ as a main component. First protective layer 30 may be composed substantially of at least one selected from the group consisting of ZnCl₂, ZnS, and ZnSO₄. However, first protective layer 30 may contain impurities in addition to these compounds.

The thickness of first protective layer 30 is, for example, thinner than the thickness of phosphor layer 20. The thickness of first protective layer 30 is, for example, in a range of 0.5 µm to 20 µm. As first protective layer 30 is thinner, a higher luminous efficiency can be achieved. The thickness of first protective layer 30 may be less than or equal to 2.0 µm or less than or equal to 1.3 µm.

The fact that wavelength conversion member 100 includes first protective layer 30 can be confirmed by performing elemental analysis of the surface of wavelength conversion member 100. Elemental analysis can be performed using, for example, an electron beam microanalyzer. The fact that wavelength conversion member 100 includes first protective layer 30 can be confirmed by observing the surface of wavelength conversion member 100 under a laser microscope. The thickness of first protective layer 30 can be measured using, for example, an electron beam microanalyzer.

Next, a method for manufacturing wavelength conversion member 100 will be described.

First, a mixed sol containing a precursor such as zinc alkoxide, phosphor particles 22, and filler particles 23 is prepared. The mixed sol is applied to substrate 10 so that a coating film is formed on substrate 10. Examples of the method for forming a coating film include a printing method. Phosphor layer 20 is obtained by gelling and firing the coating film.

In a case in which matrix 21 is single crystalline ZnO or c-axis-oriented polycrystalline ZnO, matrix 21 can be formed on substrate 10 by a solution growth method. First, substrate 10 is prepared. A crystalline ZnO thin film is formed on substrate main body 11 as thin film 12. As a method for forming the ZnO thin film, vacuum film forming methods such as an electron beam vapor deposition method, a reactive plasma vapor deposition method, a sputtering method, and a pulse laser accumulation method are used. Thin film 12 can be a single crystalline ZnO thin film or a polycrystalline ZnO thin film. Next, a layer containing phosphor particles 22 and filler particles 23 is formed on substrate 10 (on thin film 12). For example, a dispersion containing phosphor particles 22 and filler particles 23 is prepared. Substrate 10 is disposed in the dispersion, and phosphor particles 22 and filler particles 23 are deposited on substrate 10 by electrophoresis. By this, a layer containing phosphor particles 22 and filler particles 23 can be formed on substrate 10. It is also possible to form a layer containing phosphor particles 22 and filler particles 23 on substrate 10 by disposing substrate 10 in the dispersion and precipitating phosphor particles 22 and filler particles 23. It is also possible to form a layer containing phosphor particles 22 and filler particles 23 on substrate 10 using a coating solution containing phosphor particles 22 and filler particles 23 by a thin film forming method such as a printing method.

Next, matrix 21 is formed between the particles by a solution growth method using a solution containing Zn. Phosphor layer 20 is thus obtained. As the solution growth method, chemical bath deposition performed at the atmospheric pressure, hydrothermal synthesis performed at a pressure higher than the atmospheric pressure, and electrochemical deposition in which a voltage or a current is applied, and the like are used. As the solution for crystal growth, for example, an aqueous solution of zinc nitrate containing hexamethylenetetramine is used. Crystalline matrix 21 is epitaxially grown on thin film 12. Phosphor layer 20 is thus obtained.

Next, phosphor layer 20 is placed in an atmosphere of sample gas. The sample gas contains at least one selected from the group consisting of H₂S, Cl₂, and SO₂. ZnO contained in matrix 21 reacts with the sample gas in the vicinity of the surface of phosphor layer 20. First protective layer 30 is thus formed. At this time, first protective layer 30 formed is in close contact with the surface of phosphor layer 20. In other words, a gap is hardly formed between first protective layer 30 and phosphor layer 20. Hence, reflection of light is suppressed at the interface between first protective layer 30 and phosphor layer 20. First protective layer 30 is, for example, transparent and hardly absorbs visible light. In other words, high light output is achieved according to wavelength conversion member 100 fabricated by the above method. First protective layer 30 suppresses permeation of the sample gas. Hence, ZnO contained in matrix 21 hardly reacts with the sample gas after first protective layer 30 is formed.

The concentration of each of H₂S, Cl₂, and SO₂ in the sample gas may be in a range of 0.005 vol ppm to 10 vol ppm. The period during which phosphor layer 20 and the sample gas should be in contact with each other may be in a range of 1 day to 50 days. The temperature of the sample gas when the sample gas is brought into contact with phosphor layer 20 may be in a range of 1°C to 50°C.

First protective layer 30 may be fabricated by depositing at least one selected from the group consisting of ZnCl₂, ZnS, and ZnSO₄ on phosphor layer 20. Examples of the method for depositing these compounds include a sputtering method, an ion plating method, an electron beam vapor deposition method, a vacuum vapor deposition method, a chemical vapor deposition method, and a chemical vapor phase deposition method.

### (Second example)

As illustrated in FIG. 2, wavelength conversion member 110 according to a second example includes second protective layer 40. While this second example does not fully implement the claimed invention and mainly serves for illustrative purposes, parts of the disclosure herein may be used in connection with the claimed invention as will be described further below. The structure of wavelength conversion member 110 is the same as the structure of wavelength conversion member 100 of the first example except second protective layer 40. Accordingly, elements common to wavelength conversion member 100 of the first example and wavelength conversion member 110 of the present example are denoted by the same reference numerals, and the description of the elements may be omitted. In other words, the following description regarding the respective examples can be applied to each other as long as there is no technical contradiction. Furthermore, the respective examples may be combined with each other as long as there is no technical contradiction.

Second protective layer 40 is disposed on phosphor layer 20 and first protective layer 30. In detail, substrate 10, phosphor layer 20, first protective layer 30, and second protective layer 40 are arranged in the thickness direction of wavelength conversion member 110 in this order. Second protective layer 40 covers the entire surface of phosphor layer 20. Second protective layer 40 may only partially cover the surface of phosphor layer 20. In wavelength conversion member 110, the upper surface of first protective layer 30 is in contact with the lower surface of second protective layer 40. Second protective layer 40 may not be disposed on first protective layer 30. Second protective layer 40 may be disposed between phosphor layer 20 and first protective layer 30.

Second protective layer 40 contains at least one selected from the group consisting of a silicone resin, a hybrid organic-inorganic material, and glass. The strength of wavelength conversion member 110 is improved by second protective layer 40. The permeation of corrosive gas can also be further suppressed by second protective layer 40. Second protective layer 40 may contain at least one selected from the group consisting of a silicone resin, a hybrid organic-inorganic material, and glass as a main component. The hybrid organic-inorganic material may be, for example, polysilsesquioxane having a siloxane bond. Second protective layer 40 may be composed substantially of glass. The thickness of second protective layer 40 is, for example, thinner than the thickness of phosphor layer 20. The thickness of second protective layer 40 is, for example, in a range of 0.5 um to 20 pm.

The method for fabricating second protective layer 40 is not particularly limited. For example, in a case in which second protective layer 40 contains a silicone resin, second protective layer 40 can be fabricated by the following method. First, a dispersion containing a silicone resin is prepared. The dispersion is applied to first protective layer 30 so that a coating film is formed on first protective layer 30. Second protective layer 40 is formed by drying the coating film.

In a case in which second protective layer 40 contains a hybrid organic-inorganic material, second protective layer 40 can be fabricated by the following method. First, polysilsesquioxane is dissolved in benzyl alcohol, and a dispersion containing these is prepared. The dispersion is applied to first protective layer 30 so that a coating film is formed on first protective layer 30. Second protective layer 40 is obtained by thermally curing the coating film.

In a case in which second protective layer 40 contains glass, second protective layer 40 can be fabricated by the following method. First, a sol containing a precursor such as silicon alkoxide is prepared. The sol is applied to first protective layer 30 so that a coating film is formed on first protective layer 30. Second protective layer 40 is obtained by gelling and firing the coating film.

When second protective layer 40 is disposed between phosphor layer 20 and first protective layer 30, first protective layer 30 is fabricated by, for example, depositing at least one selected from the group consisting of ZnCl₂, ZnS, and ZnSO₄ on second protective layer 40.

### (Exemplary embodiment of the invention)

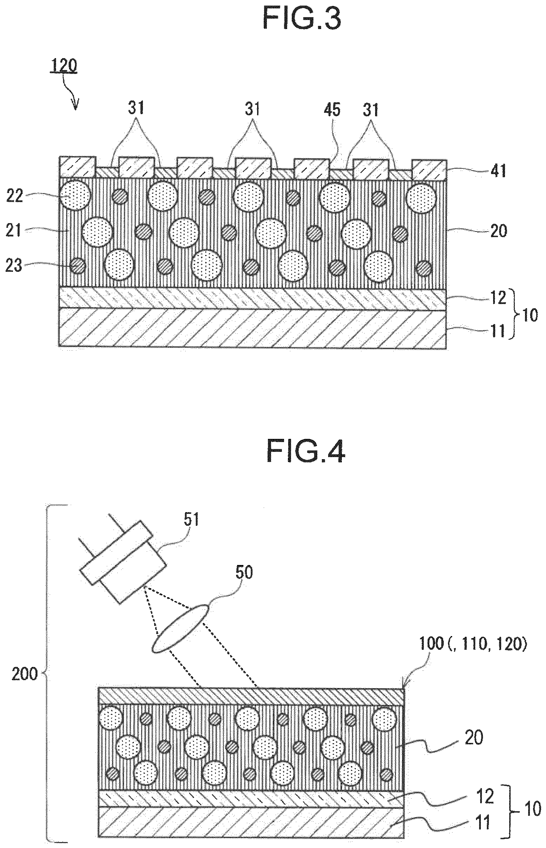

As illustrated in FIG. 3, wavelength conversion member 120 according to the present exemplary embodiment includes phosphor layer 20, first protective layer 31, and second protective layer 41. The material for first protective layer 31 is the same as the material for first protective layer 30 described in the previous example. The material for second protective layer 41 is the same as the material for second protective layer 40 described in the previous example. Second protective layer 41 has a plurality of pinholes 45. Pinholes 45 are through holes which penetrate second protective layer 41 in the thickness direction. The plurality of pinholes 45 overlap the upper surface of phosphor layer 20. A plurality of first protective layers 31 are disposed on phosphor layer 20 in the plurality of pinholes 45. In other words, the plurality of first protective layers 31 are in contact with phosphor layer 20 through the plurality of pinholes 45. The lower surface of second protective layer 41 and each lower surface of the plurality of first protective layers 31 are in contact with the upper surface of phosphor layer 20. In wavelength conversion member 120, the each thickness of the plurality of first protective layers 31 is thinner than the thickness of second protective layer 41.

The diameters of the plurality of pinholes 45 in plan view may be each in a range of 1.0 nm to 1.0 µm. The diameters of the plurality of pinholes 45 can be measured by, for example, observing the surface of second protective layer 41 under an electron microscope.

In wavelength conversion member 120, each of second protective layer 41 and the plurality of first protective layers 31 can be fabricated as follows. First, second protective layer 41 is disposed on phosphor layer 20. For the fabrication of second protective layer 41, the method described above can be utilized. Second protective layer 41 fabricated by the method described above usually has the plurality of pinholes 45. The plurality of pinholes 45 may be formed by irradiating second protective layer 41 with an ion beam. Phosphor layer 20 is exposed to the outside through the plurality of pinholes 45.

Next, phosphor layer 20 on which second protective layer 41 is disposed is placed in an atmosphere of sample gas. ZnO contained in matrix 21 reacts with the sample gas in the vicinity of the surface of phosphor layer 20 exposed to the outside. The plurality of first protective layers 31 are thus formed in the plurality of pinholes 45 of second protective layer 41.

### (Exemplary embodiment of light source)

As illustrated in FIG. 4, light source 200 includes wavelength conversion member 100 (110, 120) and light emitting element 51. Phosphor layer 20 of wavelength conversion member 100 is located between light emitting element 51 and substrate 10 of wavelength conversion member 100. Light source 200 is a reflective light source. Wavelength conversion member 110 described with reference to FIG. 2 and wavelength conversion member 120 described with reference to FIG. 3 can also be used instead of wavelength conversion member 100. While using wavelength conversion member 100 described with reference to FIG. 1 or wavelength conversion member 110 described with reference to FIG. 2 does not fully implement the claimed invention but mainly serves for illustrative purposes, using wavelength conversion member 120 described with reference to FIG. 3 represents an exemplary embodiment of the claimed light source. A combination of these wavelength conversion members 100, 110, and 120 can also be used in light source 200.

Light emitting element 51 radiates excitation light. Light emitting element 51 is typically a semiconductor light emitting element. The semiconductor light emitting element is, for example, a light emitting diode (LED), a super luminescent diode (SLD), or a laser diode (LD).

Light emitting element 51 may be composed of one LD or a plurality of LDs. The plurality of LDs may be optically coupled with each other. Light emitting element 51 radiates blue-violet light, for example. In the present disclosure, blue-violet light is light having a peak wavelength in a range of 380 nm to 420 nm.

Light source 200 further includes optical system 50. Optical system 50 may be located on the optical path of the excitation light radiated from light emitting element 51. Optical system 50 includes optical components such as a lens, a mirror, and an optical fiber.

### (Exemplary embodiment of lighting system)

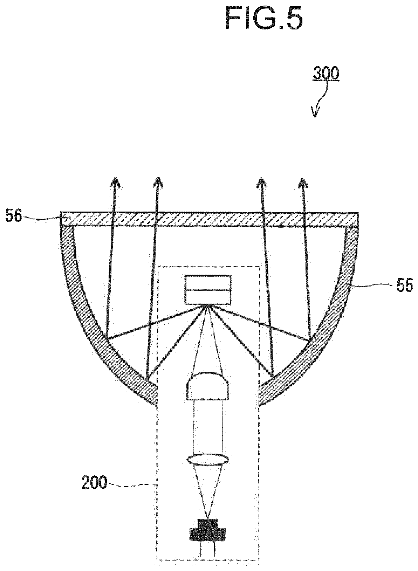

As illustrated in FIG. 5, lighting system 300 of the present exemplary embodiment includes light source 200 and optical component 55. Optical component 55 is a component for guiding light radiated from light source 200 forward, and specifically, is a reflector. Optical component 55 has, for example, a metal film of Al, Ag or the like or an Al film having a protective film formed on the surface. Filter 56 may be provided in front of light source 200. Filter 56 absorbs or scatters blue light so that coherent blue light from the light emitting element of light source 200 is not directly emitted to the outside. Lighting system 300 may be so-called reflector type or projector type. Lighting system 300 is, for example, a headlamp for vehicle.

### Examples

The present disclosure will be specifically described based on Examples. However, the present disclosure is not limited by the following Examples at all.

### (Sample 1)

First, a crystalline ZnO thin film was formed on the substrate main body. As the substrate main body, an Ag mirror with protective film (manufactured by KEIHIN KOMAKU KOGYO CO., LTD.) was used. The protective film was SiO₂. Phosphor particles were disposed on the ZnO thin film. The material for the phosphor particles was YAG (manufactured by NEMOTO & CO., LTD.).

Next, a crystalline ZnO matrix was formed on the ZnO thin film by a solution growth method. A phosphor layer containing phosphor particles embedded in a ZnO matrix was thus formed. As the solution for crystal growth, an aqueous solution of zinc nitrate containing hexamethylenetetramine was used. The concentration of hexamethylenetetramine in the aqueous solution was 0.10 mol/L. The concentration of zinc nitrate in the aqueous solution was 0.10 mol/L. In this manner, a wavelength conversion member of Sample 1 was obtained.

### (Sample 2)

A phosphor layer was fabricated on the substrate by the same method as in Sample 1. Next, the phosphor layer was placed in an atmosphere of sample gas. The sample gas contained H₂S, Cl₂, and SO₂. The concentration of H₂S in the sample gas was 0.01 vol ppm. The concentration of Cl₂ in the sample gas was 0.01 vol ppm. The concentration of SO₂ in the sample gas was 0.2 vol ppm. The temperature of the sample gas was 25°C. The humidity of the sample gas was 75% RH. The phosphor layer and the sample gas were in contact with each other for 10 days. In this manner, a wavelength conversion member of Sample 2 was obtained.

### (Observation under laser microscope)

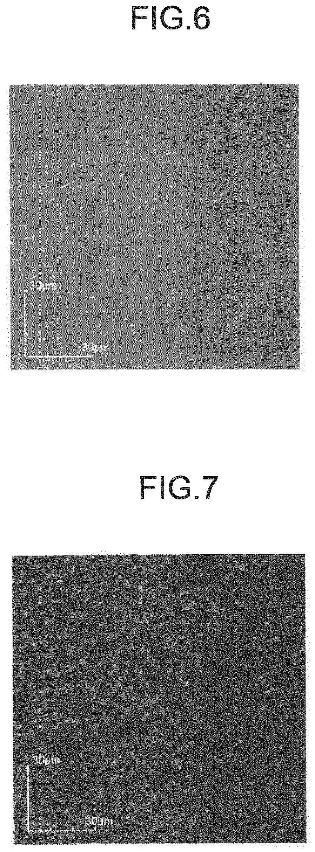

The surface of the wavelength conversion member of each of Samples 1 and 2 was observed under a laser microscope. As the laser microscope, LEXT OLS4100 (manufactured by Olympus Corporation) was used. The laser microscope images attained are illustrated in FIGS. 6 and 7. As can be seen from FIGS. 6 and 7, the surface of the wavelength conversion member of Sample 2 was different from the surface of the wavelength conversion member of Sample 1. From this, it is inferred that the wavelength conversion member of Sample 2 includes the first protective layer.

### (Analysis using electron microanalyzer)

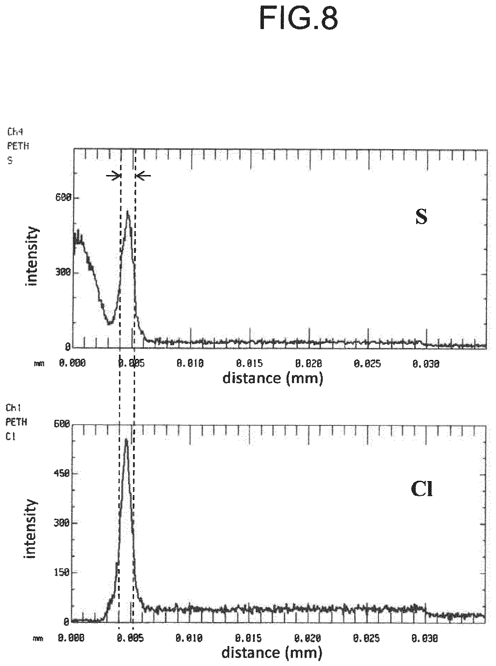

The wavelength conversion member of Sample 2 was analyzed using an electron beam microanalyzer. As the electron beam microanalyzer, JXA-8900R (manufactured by JEOL Ltd.) was used. The analysis results are illustrated in FIG. 8. In FIG. 8, a graph showing the detection result of S atom and a graph showing the detection result of Cl atom are displayed side by side. The horizontal axis of the graph indicates the distance from the detection unit of the electron beam microanalyzer in the thickness direction of the wavelength conversion member. The vertical axis of the graph indicates the intensity of the detection signal. As can be seen from FIG. 8, S atom and Cl atom were detected in a range surrounded by a broken line. The range surrounded by a broken line was 1.3 µm. In other words, the first protective layer of the wavelength conversion member of Sample 2 had a thickness of 1.3 µm.

### (Sample 3)

A wavelength conversion member of Sample 3 was obtained by the same method as in Sample 2 except that the composition of the phosphor layer was changed. Specifically, Al₂O₃ particles as filler particles were added to the phosphor layer. The volume ratio of the phosphor particles to the filler particles was adjusted so that the required chromaticity of light was attained. The ratio of the volume of the phosphor particles to the total value of the volume of the phosphor particles and the volume of the filler particles was 65 vol%. The ratio of the volume of the filler particles to the total value of the volume of the phosphor particles and the volume of the filler particles was 35 vol%. Next, the wavelength conversion member obtained was irradiated with excitation light. LD was used as an excitation light source. The wavelength of the excitation light was 447 nm. The energy density of the excitation light was 13.9 kW/mm². At this time, the luminescence intensity of light radiated from the wavelength conversion member and the CIE chromaticity coordinates of the light were measured using a luminance meter. As the luminance meter, an imaging color luminance meter LumiCam1300 (manufactured by Instrument Systems) was used. The color temperature of light was calculated based on the CIE chromaticity coordinates attained. Furthermore, the temperature of the surface of the phosphor layer contained in the wavelength conversion member was measured by infrared thermography. As the infrared thermography, FLIR T640 (manufactured by FLIR Systems Japan) was used. The results attained are presented in Table 1.

### (Sample 4)

A first protective layer was fabricated on the phosphor layer by the same method as in Sample 3 except that the composition of the phosphor layer was changed. In detail, the volume ratio of the phosphor particles to the filler particles was adjusted so that the required chromaticity of light was attained. The ratio of the volume of the phosphor particles to the total value of the volume of the phosphor particles and the volume of the filler particles was 50 vol%. The ratio of the volume of the filler particles to the total value of the volume of the phosphor particles and the volume of the filler particles was 50 vol%. Next, a sol containing tetraethyl orthosilicate was prepared. The sol was applied to the first protective layer so that a coating film was formed on the first protective layer. The coating film was gelled and fired to cure the coating film, and a second protective layer was thus formed on the first protective layer. Firing was performed at 160°C for 3 hours. The second protective layer was composed of glass. In this manner, a wavelength conversion member of Sample 4 was obtained. The wavelength conversion member of Sample 4 was irradiated with excitation light by the same method as in Sample 3. At this time, the luminescence intensity of the light radiated from the wavelength conversion member, the CIE chromaticity coordinates of the light, the color temperature of the light, and the temperature of the surface of the phosphor particles contained in the wavelength conversion member were measured or calculated. The results attained are presented in Table 1.

### (Sample 5)

A phosphor layer was fabricated on the substrate by the same method as in Sample 1 except that the composition of the phosphor layer was changed. Specifically, Al₂O₃ particles as filler particles were added to the phosphor layer. The volume ratio of the phosphor particles to the filler particles was adjusted so that the required chromaticity of light was attained. The ratio of the volume of the phosphor particles to the total value of the volume of the phosphor particles and the volume of the filler particles was 50 vol%. The ratio of the volume of the filler particles to the total value of the volume of the phosphor particles and the volume of the filler particles was 50 vol%. Next, a second protective layer was fabricated on the phosphor layer. The second protective layer was fabricated by the same method as in Sample 4. Next, the phosphor layer was placed in an atmosphere of sample gas. The composition of the sample gas, the temperature of the sample gas, the humidity of the sample gas, and the period during which the phosphor layer was in contact with the sample gas were the same as those in Sample 2. A plurality of first protective layers were thus formed on the phosphor layer in a plurality of pinholes of the second protective layer. In this manner, a wavelength conversion member of Sample 5 was obtained. The wavelength conversion member of Sample 5 was irradiated with excitation light by the same method as in Sample 3. At this time, the luminescence intensity of the light radiated from the wavelength conversion member, the CIE chromaticity coordinates of the light, the color temperature of the light, and the temperature of the surface of the phosphor particles contained in the wavelength conversion member were measured or calculated. The results attained are presented in Table 1.

### (Sample 6)

A wavelength conversion member of Sample 6 was obtained by the same method as in Sample 1 except that the composition of the phosphor layer was changed. Specifically, Al₂O₃ particles as filler particles were added to the phosphor layer. The volume ratio of the phosphor particles to the filler particles was adjusted so that the required chromaticity of light was attained. The ratio of the volume of the phosphor particles to the total value of the volume of the phosphor particles and the volume of the filler particles was 65 vol%. The ratio of the volume of the filler particles to the total value of the volume of the phosphor particles and the volume of the filler particles was 35 vol%. The wavelength conversion member of Sample 6 was irradiated with excitation light by the same method as in Sample 3. At this time, the luminescence intensity of the light radiated from the wavelength conversion member, the CIE chromaticity coordinates of the light, the color temperature of the light, and the temperature of the surface of the phosphor particles contained in the wavelength conversion member were measured or calculated. The results attained are presented in Table 1.

### (Sample 7)

First, a mixed sol containing tetraethyl orthosilicate, phosphor particles, and filler particles was prepared. The material for the phosphor particles was YAG (manufactured by NEMOTO & CO., LTD.). The filler particles were Al₂O₃ particles. Next, the mixed sol was applied to the substrate so that a coating film was formed on the substrate. As the substrate, an Ag mirror with protective film (manufactured by KEIHIN KOMAKU KOGYO CO., LTD.) was used. Next, the phosphor layer was formed by drying and firing the coating film. In this manner, a wavelength conversion member of Sample 7 was obtained. The phosphor layer of the wavelength conversion member of Sample 7 had a glass matrix instead of a ZnO matrix. The glass matrix contained silicone as a main component. The ratio of the volume of the phosphor particles to the total value of the volume of the phosphor particles and the volume of the filler particles was 50 vol%. The ratio of the volume of the filler particles to the total value of the volume of the phosphor particles and the volume of the filler particles was 50 vol%. The wavelength conversion member of Sample 7 was irradiated with excitation light by the same method as in Sample 3. At this time, the luminescence intensity of the light radiated from the wavelength conversion member, the CIE chromaticity coordinates of the light, the color temperature of the light, and the surface temperature of the phosphor particles contained in the wavelength conversion member were measured or calculated. The results attained are presented in Table 1.

### (Change in color temperature with time)

The wavelength conversion member of each of Samples 3 to 7 was placed in an atmosphere of corrosive gas. The corrosive gas contained H₂S, Cl₂, NO₂, and SO₂. The concentration of H₂S in the corrosive gas was 0.01 vol ppm. The concentration of Clz in the corrosive gas was 0.01 vol ppm. The concentration of NO₂ in the corrosive gas was 0.2 vol ppm. The concentration of SO₂ in the corrosive gas was 0.2 vol ppm. The temperature of the corrosive gas was 25°C. The humidity of the corrosive gas was 75% RH. The wavelength conversion member and the corrosive gas were in contact with each other for 10 days.

The wavelength conversion member of each of Samples 3 to 7 was irradiated with excitation light after being in contact with the corrosive gas. At this time, the CIE chromaticity coordinates of light radiated from the wavelength conversion member was measured using a luminance meter. The color temperature of light was calculated based on the CIE chromaticity coordinates attained. The results attained are presented in Table 1.

**[Table 1]**

| Sample | Before contact with corrosive gas | | | | | After contact with corrosive gas | | | Evaluation |
|---|---|---|---|---|---|---|---|---|---|
| | Luminescence intensity [a.u.] | Temperature of surface of phosphor (°C) | CIE chromaticity coordinates | | Color temperature (K) | CIE chromaticity coordinates | | Color temperature (K) | |
| | | | x value | y value | | x value | y value | | |
| 3 | 115 | 60 | 0.3325 | 0.3411 | 5500 | 0.3333 | 0.3427 | 5444 | ○ |
| 4 | 115 | 60 | 0.3325 | 0.3411 | 5500 | 0.3333 | 0.3427 | 5444 | ○ |
| 5 | 115 | 60 | 0.3325 | 0.3411 | 5500 | 0.3451 | 0.3516 | 5000 | ○ |
| 6 | 115 | 60 | 0.3325 | 0.3411 | 5500 | 0.4169 | 0.4218 | 3500 | × |
| 7 | 100 | 150 | 0.3325 | 0.3411 | 5500 | 0.3451 | 0.3516 | 5000 | × |

In Table 1, it was judged that the characteristics of the wavelength conversion member were practically sufficient (o) in a case in which the temperature of the phosphor surface was less than or equal to 100°C and the change in color temperature of light before and after contact with the corrosive gas was in a range of 1000 K. It was judged that the characteristics of the wavelength conversion member were insufficient (x) in a case in which the temperature of the phosphor surface or the change in color temperature of light did not satisfy the above requirement.

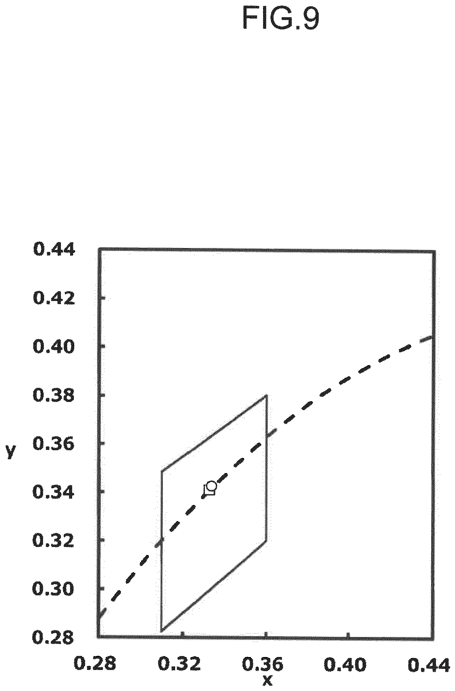

FIGS. 9 to 11 illustrate changes in CIE chromaticity coordinates of light radiated from the wavelength conversion members of Samples 3, 5 and 6, respectively. In the graph of each of FIGS. 9 to 11, a square mark indicates the CIE chromaticity coordinates of light radiated from the wavelength conversion member before being brought into contact with the corrosive gas. A circular mark indicates the CIE chromaticity coordinates of light radiated from the wavelength conversion member after being brought into contact with the corrosive gas. The color temperature range of 4500 to 6500 K is surrounded by a closing line. A dotted line indicates the relation between the chromaticity and color temperature of the light radiated from a black body.

As can be seen from FIG. 9, the chromaticity of light radiated from the wavelength conversion member of Sample 3 hardly changed before and after contact with the corrosive gas. In other words, the wavelength conversion member of Sample 3 exhibited high reliability. The wavelength conversion member of Sample 4 also exhibited high reliability in the same manner as in Sample 3.

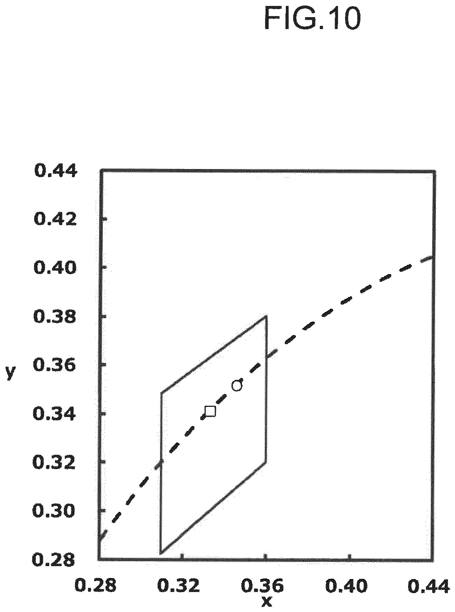

As can be seen from FIG. 10, the change in color temperature of light before and after contact with the corrosive gas was in a range of 1000 K in the wavelength conversion member of Sample 5. In other words, the wavelength conversion member of Sample 5 exhibited practically sufficient reliability.

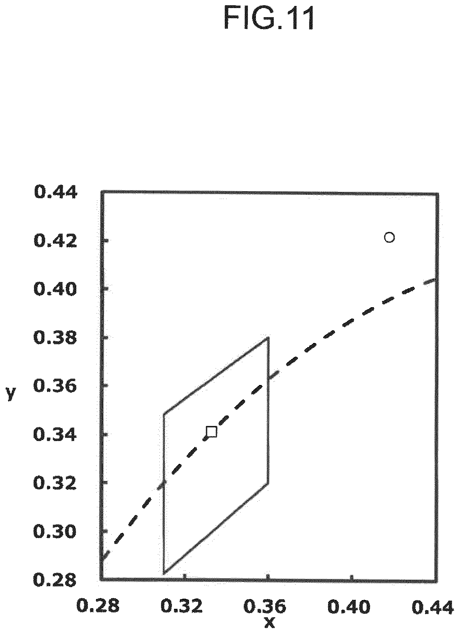

As can be seen from FIG. 11, the chromaticity of light radiated from the wavelength conversion member of Sample 6 greatly changed before and after contact with the corrosive gas. The reliability of the wavelength conversion member of Sample 6 was inferior to the reliability of the wavelength conversion member of Samples 3 to 5.

As can be seen from the results in Table 1, the temperature (150°C) of the surface of the phosphor contained in the wavelength conversion member of Sample 7 was higher than the temperature of the surface of Samples 3 to 6. The luminescence intensity of the light radiated from the wavelength conversion member decreases in a case in which the temperature of the surface of the phosphor is high. The luminescence intensity of the light radiated from the wavelength conversion member of Sample 7 was lower than the luminescence intensity in Samples 3 to 6.

### INDUSTRIAL APPLICABILITY

The light source of the present disclosure can be used in, for example, general lighting systems such as a ceiling light, special lighting systems such as spotlights, stadium lighting, and studio lighting, vehicle lighting systems such as headlamps, and projection apparatuses such as a projector and a head-up display. Moreover, the light source of the present disclosure can be used as, for example, endoscope light; and a light source in imaging devices such as digital cameras, cell phones, smartphones, liquid crystal display devices such as personal computer (PC) monitors, notebook personal computers, television, personal digital assistants (PDX), smartphones, tablet PCs, and cell phones, and the like.

### REFERENCE SIGNS LIST

- 10: substrate
- 11: substrate main body
- 12: thin film
- 20: phosphor layer
- 21: matrix
- 22: phosphor particle
- 23: filler particle
- 30, 31: first protective layer
- 40, 41: second protective layer
- 45: pinhole
- 50: optical system
- 51: light emitting element
- 55: optical component
- 56: filter
- 100, 110, 120: wavelength conversion member
- 200: light source
- 300: lighting system

## Claims

1. A wavelength conversion member (120) comprising:
a substrate (10),
a phosphor layer (20) formed on the substrate (10), the phosphor layer (20) having a matrix (21) containing ZnO and phosphor particles (22) embedded in the matrix (21);
a first protective layer (31) that contains at least one selected from the group consisting of ZnCl₂, ZnS, and ZnSO₄, and covers the phosphor layer (20);
a second protective layer (41) that contains at least one selected from the group consisting of a silicone resin, a hybrid organic-inorganic material, and glass and covers the phosphor layer (20), the second protective layer (41) having a plurality of pinholes (45); and
wherein a plurality of the first protective layers (31) are disposed on the phosphor layer (20) in the plurality of the pinholes (45), and
the ZnO is c-axis-oriented polycrystalline ZnO.

2. The wavelength conversion member (120) according to claim 1, wherein the first protective layer (31) is in contact with the phosphor layer (20).

3. The wavelength conversion member (120) according to claim 1 or 2, wherein the phosphor layer (20) further has filler particles (23).

4. The wavelength conversion member (120) according to any one of claims 1 to 3, wherein a thickness of the first protective layer (31) is in a range of 0.5 µm to 20 µm.

5. A light source (200) comprising:
a light emitting element (51); and
the wavelength conversion member (120) according to any one of claims 1 to 4, which is adapted to receive excitation light emitted from the light emitting element (51) and is adapted to radiate fluorescence.

## Patentansprüche

1. Wellenlängenumwandlungselement (120), aufweisend:
ein Substrat (10),
eine auf dem Substrat (10) gebildete Leuchtstoffschicht (20), wobei die Leuchtstoffschicht (20) eine Matrix (21) aufweist, die ZnO und in die Matrix (21) eingebettete Leuchtstoffteilchen (22) enthält;
eine erste Schutzschicht (31), die zumindest ein Mitglied ausgewählt aus der Gruppe bestehend aus ZnCl₂, ZnS und ZnSO₄ enthält und die Leuchtstoffschicht (20) bedeckt;
eine zweite Schutzschicht (41), die zumindest ein Mitglied ausgewählt aus der Gruppe bestehend aus einem Silikonharz, einem hybriden organischanorganischen Material und Glas enthält und die Leuchtstoffschicht (20) bedeckt, wobei die zweite Schutzschicht (41) eine Vielzahl von Nadellöchern (45) aufweist; und
wobei eine Vielzahl der ersten Schutzschichten (31) auf der Leuchtstoffschicht (20) in der Vielzahl von Nadellöchern (45) angeordnet sind, und das ZnO ein c-Achsen-orientiertes polykristallines ZnO ist.

2. Wellenlängenumwandlungselement (120) nach Anspruch 1, wobei die erste Schutzschicht (31) in Kontakt mit der Leuchtstoffschicht (20) ist.

3. Wellenlängenumwandlungselement (120) nach Anspruch 1 oder 2, wobei die Leuchtstoffschicht (20) ferner Füllstoffpartikel (23) aufweist.

4. Wellenlängenumwandlungselement (120) nach einem der Ansprüche 1 bis 3, wobei eine Dicke der ersten Schutzschicht (31) in einem Bereich von 0,5 µm bis 20 µm liegt.

5. Lichtquelle (200), aufweisend:
ein lichtemittierendes Element (51); und
das Wellenlängenumwandlungselement (120) nach einem der Ansprüche 1 bis 4, das eingerichtet ist, vom Lichtemissionselement (51) emittiertes Anregungslicht zu empfangen und Fluoreszenz abzustrahlen.

## Revendications

1. Élément (120) de conversion de longueur d'onde, l'élément comprenant :
un substrat (10),
une couche (20) de luminophore formée sur le substrat (10), la couche (20) de luminophore comportant une matrice (21) contenant du ZnO et des particules (22) de luminophore intégrées dans la matrice (21) ;
une première couche protectrice (31) contenant au moins un composé choisi dans le groupe constitué par ZnCl₂, ZnS et ZnSO₄, et recouvrant la couche (20) de luminophore ;
une seconde couche protectrice (41) contenant au moins un matériau choisi dans le groupe constitué par une résine de silicone, un matériau organique-inorganique hybride et du verre, et recouvrant la couche (20) de luminophore, la seconde couche protectrice (41) comportant une pluralité de trous d'épingle (45) ; et
dans lequel une pluralité des premières couches protectrices (31) est disposée sur la couche (20) de luminophore dans la pluralité de trous d'épingle (45), et
le ZnO est un ZnO polycristallin orienté sur l'axe c.

2. L'élément (120) de conversion de longueur d'onde selon la revendication 1, dans lequel la première couche protectrice (31) est en contact avec la couche (20) de luminophore.

3. L'élément (120) de conversion de longueur d'onde selon les revendications 1 ou 2, dans lequel la couche (20) de luminophore comporte en outre des particules (23) de remplissage.

4. L'élément (120) de conversion de longueur d'onde selon l'une quelconque des revendications 1 à 3, dans lequel une épaisseur de la première couche protectrice (31) est comprise entre 0,5 µm et 20 µm.

5. Source de lumière (200) comprenant :
un élément émetteur de lumière (51) ; et
l'élément (120) de conversion de longueur d'onde selon l'une quelconque des revendications 1 à 4, lequel est adapté à recevoir une lumière d'excitation émise par l'élément émetteur de lumière (51) et est adapté à émettre une fluorescence.
